# EUROPEAN PATENT SPECIFICATION

(11) **EP 0 421 425 B1**
(45) Date of publication and mention of the grant of the patent: **09.08.1995**
(21) Application number: 90119055.3
(22) Date of filing: 04.10.1990
(51) Int. Cl.: G11C 16/06, G06F 13/40, G11C 7/00

(54) **Memory control system**
Speicher-Steuersystem
Système de commande de mémoire

(30) Priority: 05.10.1989 JP 258765/89
(43) Date of publication of application: 10.04.1991
(73) Proprietor: KABUSHIKI KAISHA TOSHIBA, Kawasaki-shi, Kanagawa-ken 210 (JP)
(72) Inventor: Dewa, Koichi, c/o Intellectual Property Division, Minato-ku, Tokyo 105 (JP)
(74) Representative: Henkel, Feiler, Hänzel & Partner

(56) References cited:
- EP-A- 0 145 320
- WO-A-88/09007
- US-A- 4 623 986
- US-A- 4 623 986
- THE 15TH ANNUAL INTERNATIONAL SYMPOSIUM ON COMPUTER ARCHITECTURE vol. 15, 30
- May 1988, HONOLULU, HAWAII pages 152 - 159; B.SPRUNT ET AL.: 'Priority-Driven,Preemptive I/O Controllers for Real-Time Systems'
- IEEE SPECTRUM. vol. 25, no. 1, January 1988, NEW YORK US pages 32 - 34; J.VOELCKER: 'Personal Computers'
- PATENT ABSTRACTS OF JAPAN vol. 6, no. 221 (P-153)(1099) 5 November 1982
- A. LESEA, R. ZAKS: MICROPROCESSOR INTERFACE TECHNIKEN, MSB, MARKDORF, DE, 1979, pages 47-49

## Description

This invention relates to a memory control system.

In the personal computer field, a battery backup memory and a nonvolatile memory are used as a memory for storing system arrangement information and passwords for the purpose of an expansion of the system scale, data security, etc. An EEPROM (electrically erasable programmable read only memory) is also used as a read only memory capable of electrically performing write/erase of data.

In controlling an EEPROM, a special input/cutput port is to be set as a support by the computer. Therefore, control of overall system is complex, and the hardware compativility to the conventional computer system can not be obtained.

Computers are demanded which are capable of controlling an EEPROM and have the hardware compatibility to conventional computers.

Prior art document A. LESEA, R. ZAKS: MICROPROCESSOR INTERFACE TECHNIKEN, MSB, Markdorf, DE, 1979, pages 47-49, discloses a memory control system comprising an input/output device (E/A), a data storing means, a main control means, and sub-control means consisting of two NAND gates for controlling the input/output device in accordance with a control command signal.

Further, prior art document US-A-4 623 986 a memory access controller, in which a sub-control means receives a control command signal from a main control means to set the registers of the sub-control means selectively into a memory loading and a video information reception mode.

It is an object of the present invention to provide a computer system, which enables erasing/reading out/writing data with respect to an electrically programmable memory, without modifying a hardware for the control of a conventional central processing unit and further without providing an additional input/output port.

To solve this object the present invention provides a computer system as specified in claim 1.

The computer system comprises especially an input/output device, data storing means for storing data; and main control means for outputting a control command signal having one of a memory control command and an input/output device control command. Further, command storing means store a plurality of memory control commands and a plurality of input/output device control commands. It is determined whether or not a control command included in the control command signal output from the main control means is the memory control command, and a control signal corresponding to the control command signal is output to the data storing means when the control command signal is the memory control command, to access the data storing means.

This invention can be more fully understood from the following detailed description when taken in conjunction with the accompanying drawings, in which:
Fig. 1 is a block diagram illustrating the arrangement of a system embodying this invention;
Fig. 2 is a block diagram of an EEPROM used in the system of this invention;
Fig. 3 is a block diagram showing the arrangement of a sub-CPU used in the system of the invention; and
Fig. 4 is an operational flowchart of a sub-CPU used in the system.

One embodiment of the invention will be described with reference to the accompanying drawings.

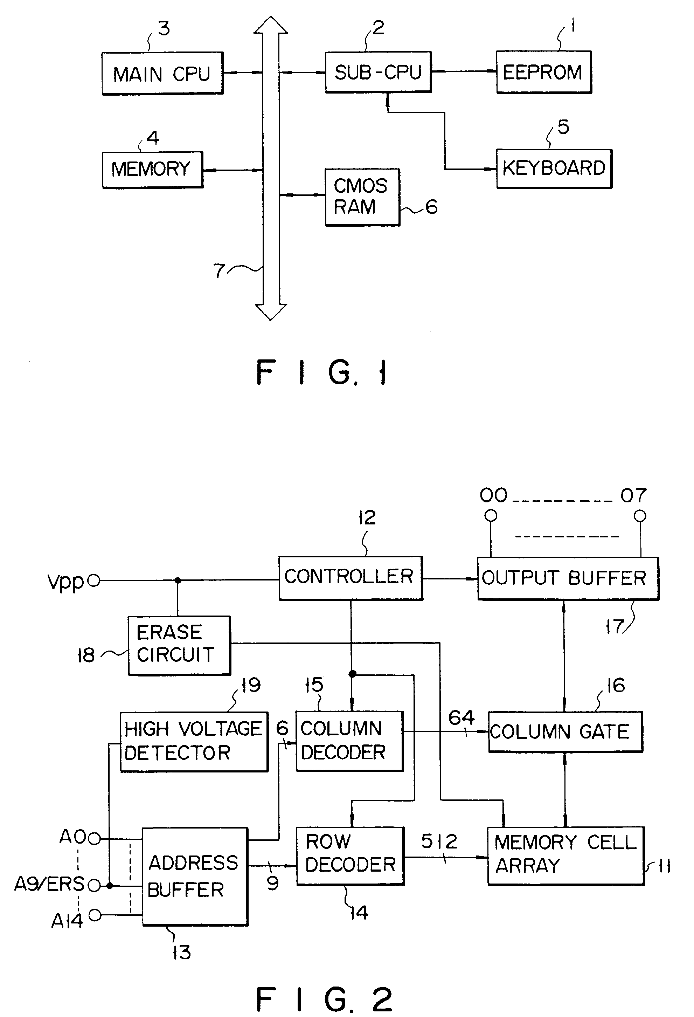

As shown in Fig. 1, the system according to this invention comprises an EEPROM (electrically erasable programmable read only memory) 1, a sub-CPU (central processing unit) 2, a main CPU 3, a memory 4, a keyboard 5, a CMOS RAM (complementary metal oxide silicon random access memory) 6 and a bus 7.

The EEPROM 1 is a read only memory capable of electrically erasing data and, in this embodiment, is one of CMOS type of Toshiba Corp., designated TC58257AP/AF of 32768 words × 8 bits. Fig. 2 shows schematic structural block diagram of the EEPROM 1. In the figure, the EEPROM 1 comprises a memory cell array 11, a controller 12, an address buffer 13, a row decoder 14, a column decoder 15, a column gate 16, an output buffer 17, an erase circuit 18, and a high voltage detector 19. The memory cell array 11 has a structure of 32768 × 8 bits and is capable of electrically performing erase/read/write of data. Further, an access time of the memory cell array 11 is about 170 ns.

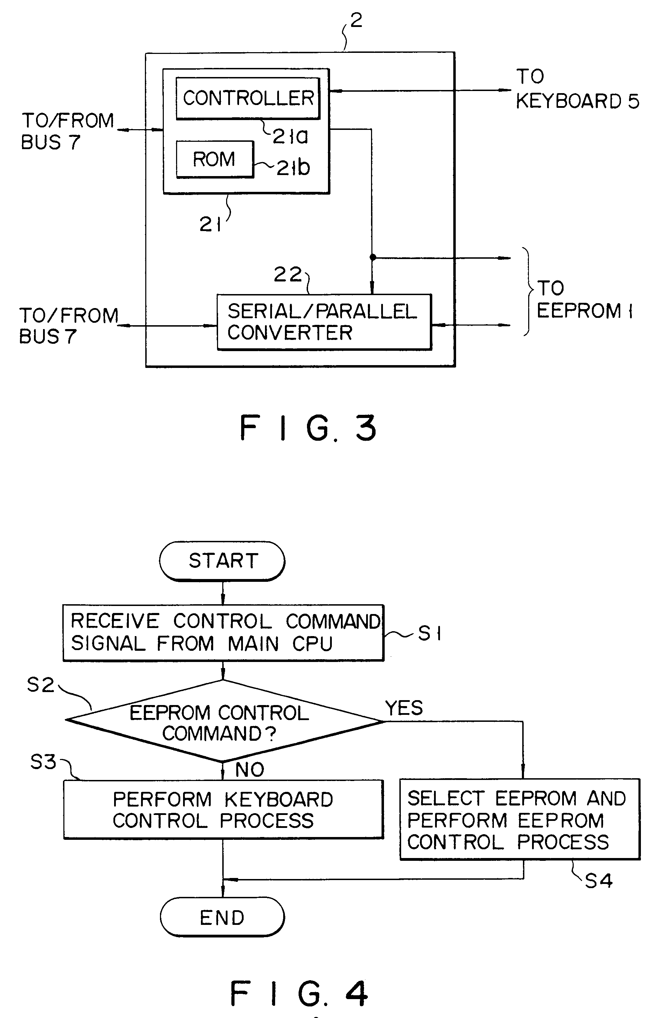

The sub-CPU 2 has functions to operate as a keyboard controller for controlling the keyboard 5 and to perform erase/read/write of data stored in the EEPROM 1. Further, as shown in Fig. 3, the sub-CPU 2 has a determination processing circuit 21 and a serial/parallel converter 22.

The determination processing circuit 21 includes a controller 21a and a ROM 21b, receives a control command signal output from the main CPU 3 via the bus 7, and performs a determination process of the received control command signal. More specifically, control commands having keyboard control commands and EEPROM control commands are stored in the ROM 21b previously, and the controller 21a determines whether a control command included in the control command signal is the EEPROM control command or the keyboard control command by comparing the control command included in the control command signal with the control command stored in the ROM 21b. When the control command is the keyboard control command, keyboard control is performed, and when the control command is the EEPROM control command, control of the EEPROM is executed. Responsive to the kind of the EEPROM control command, erase/read/write operations are performed.

When the control command included in the control command signal output from the main CPU 3 is determined to be an EEPROM control command by the controller 21a of the determination processing circuit 21, the serial/parallel converter 22 converts parallel data from the bus 7 into serial data and serial data from the EEPROM 1 into parallel data.

The main CPU 3 controls the entire system and outputs control command signals, etc. to the sub-CPU 2.

The memory 4 stores a system control program and application programs.

The CMOS RAM 6 is utilized for a backup of the data, etc.

The sub-CPU 2, main CPU 3, memory 4 and CMOS RAM 6 are interconnected to the bus 7.

The operation of the sub-CPU according to this invention will be described with reference to the flowchart of Fig. 4.

In Fig. 4, a control command signal from the main CPU 3 is received in step S1.

In step S2, it is determined that whether or not the control command included in the received control command signal is an EEPROM control command. In other words, the received control command is compared with the control command stored in the ROM 21b.

In step S2, when the received control command is not the EEPROM control command, it is determined that the received control command is a keyboard control command and keyboard control process is performed (step S3).

On the other hand, in step S2, when the received control command is the EEPROM control command, the EEPROM 1 is selected and EEPROM control process is performed (step S4). That is, erase/read/write of data are performed depending on the kind of the EEPROM control command.

As has been described above, control of the EEPROM is performed by providing a control command signal from the main CPU to the sub-CPU capable of erasing/reading out/writing data with respect to the EEPROM, without modifying a hardware for the control of a conventional main CPU and further without providing an additional input/output port.

## Claims

1. A computer system including a central processing unit (CPU) (3) for controlling the computer system, means (7) for communicating data to be processed by the CPU (3), data storing means (4, 6) and a sub-controller (2) connected to the communicating means (7), an input/output device (5) connected to the communicating means through the sub-controller (2),
an electrically programmable memory (1) connected to the communicating means (7) through the sub-controller (2);
said CPU (3), connected to the communicating means (7), being arranged for outputting control commands comprising a memory control command to control the electrically programmable memory (1) and an input/output device control command to control the input/output device (5);
said sub-controller (2) including:
means (21, S1) for receiving the control command output from the CPU (3),
means (21a, 21b, S2) for determining whether the received control command is a memory control command or an input/output device control command, and
means (21, S3, S4) for selectively performing a memory access control process to store data into the electrically programmable memory (1) when the received control command is the memory control command, and an input/output control process for controlling the input/output device when the received control command is the device control command.

2. The computer system according to claim 1, characterized in that the memory control command comprises at least one of a data erase command, a data read command and a data write command.

3. The computer system according to claim 1 or 2, characterized in that that the input/output device (5) comprises a keyboard.

4. The computer system according to any one of claims 1 to 3, characterized in that said electrically programmable memory (1) comprises an electrically erasable programmable read only memory.

## Patentansprüche

1. Computersystem mit einer Zentraleinheit (CPU) (3) zum Steuern des Computersystems, einer Einrichtung (7) zur Kommunikation von durch die CPU (3) zu verarbeitenden Daten, einer Datenspeichereinrichtung (4, 6) und einem Hilfs-Controller (2), der mit der Kommunikationseinrichtung (7) verbunden ist, einer Eingabe/Ausgabevorrichtung (5), die mit der Kommunikationseinrichtung durch den Hilfs-Controller (2) verbunden ist, einem elektrisch programmierbaren Speicher (1), der mit der Kommunikationseinrichtung (7) über den Hilfs-Controller (2) verbunden ist,
wobei die mit der Kommunikationseinrichtung (7) verbundene CPU (3) angeordnet ist zum Ausgeben von Steuerbefehlen mit einem Speichersteuerbefehl zum Steuern des elektrisch programmierbaren Speichers (1) und einem Eingabe/Ausgabevorrichtungs- Steuerbefehl zum Steuern der Eingabe/Ausgabe-Vorrichtung (5),
wobei der Hilfs-Controller (2) aufweist:
eine Einrichtung (21, S1) zum Empfangen des von der CPU (3) ausgegebenen Steuerbefehls,
eine Einrichtung (21a, 21b, S2) zum Bestimmen, ob der empfangene Steuerbefehl der Speichersteuerbefehl oder Eingabe/Ausgabevorrichtungs-Steuerbefehl ist, und
eine Einrichtung (21, S3, S4) zum wahlweisen Durchführen eines Speicherzugriffsteuerprozesses zum Speichern von Daten in dem elektrisch programmierbaren Speicher (1),wenn der empfangene Steuerbefehl der Speichersteuerbefehl ist, und eines Eingabe/Ausgabe-Steuerprozesses zum Steuern der Eingabe/Ausgabe-Vorrichtung, wenn der empfange Steuerbefehl der Vorrichtungssteuerbefhel ist.

2. Computersystem nach Anspruch 1, dadurch gekennzeichnet, daß der Speichersteuerbefehl wenigstens einen Datenlöschbefehl, einen Datenlesebefehl und einen Datenschreibbefehl umfaßt.

3. Computersystem nach Anspruch 1 oder 2, dadurch gekennzeichnet, daß die Eingabe/Ausgabe-Vorrichtung (5) ein Tastenfeld umfaßt.

4. Computersystem nach einem der Ansprüche 1 bis 3, dadurch gekennzeichnet, daß der elektrisch programmierbare Speicher (1) einen elektrisch löschbaren programmierbaren Festwertspeicher umfaßt.

## Revendications

1. Système de traitement de l'information incluant une unité centrale de traitement (CPU) (3) pour commander le système de traitement de l'information, un moyen (7) pour transmettre des données à traiter par l'unité CPU (3), des moyens à mémoire de données (4, 6) et un sous-contrôleur (2) connectés au moyen de transmission (7), un dispositif d'entrée/de sortie (5) connecté au moyen de transmission par le sous-contrôleur (2) ;
une mémoire programmable électriquement (1) connectée au moyen de transmission (7) par le sous-contrôleur (2) ;
ladite unité CPU (3), connectée au moyen de transmission (7), étant agencé pour sortir des instructions de commande comprenant une instruction de commande de mémoire afin de commander la mémoire programmable électriquement (1) et une instruction de commande de dispositif d'entrée/de sortie afin de commander le dispositif d'entrée/de sortie (5) ;
ledit sous-contrôleur (2) comprenant :
un moyen (21, S1) pour recevoir l'instruction de commande sortie de l'unité CPU (3),
des moyens (21a, 21b, S2) pour déterminer si l'instruction de commande reçue est une instruction de commande de mémoire ou une instruction de commande de dispositif d'entrée/de sortie, et,
un moyen (21, S3, S4) pour exécuter sélectivement une opération de commande d'accès à la mémoire afin de mémoriser des données dans la mémoire programmable électriquement (1) quand l'instruction de commande reçue est l'instruction de commande de mémoire, et une opération de commande de dispositif d'entrée/de sortie afin de commander le dispositif d'entrée/de sortie quand l'instruction de commande reçue est l'instruction de commande de dispositif.

2. Système de traitement de l'information selon la revendication 1, caractérisé en ce que l'instruction de commande de mémoire comprend au moins l'une d'une instruction d'effacement de données, d'une instruction de lecture de données et d'une instruction d'écriture de données.

3. Système de traitement de l'information selon l'une quelconque des revendications 1 et 2, caractérisé en ce que le dispositif d'entrée/de sortie (5) est constitué par un clavier.

4. Système de traitement de l'information selon l'une quelconque des revendications 1 à 3, caractérisé en ce que ladite mémoire programmable électriquement (1) est constituée par une mémoire morte programmable effaçable électriquement.
